# EUROPÄISCHE PATENTANMELDUNG

(11) **EP 1 562 292 A1**
(43) Veröffentlichungstag der Anmeldung: **10.08.2005**
(21) Anmeldenummer: 04029401.9
(22) Anmeldetag: 11.12.2004
(51) Int. Cl.: H03K 17/96

(54) **Bedienfeld für ein elektronisches Haushaltsgerät**

(30) Priorität: 20.12.2003 DE 10360162; 26.02.2004 DE 102004009357
(71) Anmelder: Diehl AKO Stiftung & Co. KG, 88239 Wangen (DE)
(72) Erfinder: Wiekenberg, Günther, 90513 Zirndorf (DE)
(74) Vertreter: Diehl Patentabteilung

(57) **Zusammenfassung**

Ein Bedienfeld für ein elektronisches Gerät, insbesondere Haushaltsgerät, enthält mehrere Bedienelemente (10, 12) zum Eingeben von Stellwerten in eine Steuerung (µC) des elektronischen Geräts und eine Anzeigeeinheit zum Anzeigen von eingegebenen Stellwerten und/oder anderen Informationen, wobei die mehreren Bedienelemente (10, 12) fortlaufend im Wechsel freigegeben werden. Die mehreren Bedienelemente (10, 12) weisen wenigstens ein Bedienelement einer ersten Art (10) und wenigstens ein Bedienelement einer zweiten Art (12) auf, wobei das wenigstens eine Bedienelement der zweiten Art (12) ein Berührungsschalter mit einem digitalen (High/Low-)Ausgangssignal ist und zwischen die Steuerung und das Bedienelement der zweiten Art (12) eine Transistorschaltung (16) geschaltet ist, welche das Schaltverhalten des Bedienelements der zweiten Art (12) an das Schaltverhalten des wenigstens einen Bedienelements der ersten Art (10) adaptiert. Auf diese Weise können Bedienelemente der zweiten Art (12), wie beispielsweise kapazitive Berührungsschalter, in bereits bestehende Bedienfelder beispielsweise ausschließlich mit Infrarot-Sensoren (10) integriert werden.

## Beschreibung

Die vorliegende Erfindung betrifft ein Bedienfeld für ein elektronisches Gerät, insbesondere für ein elektronisches Haushaltsgerät, nach dem Oberbegriff des Anspruchs 1.

Derartige Bedienfelder sind beispielsweise als System "DIEHL TC2" der Anmelderin oder als System "EGO Touch Control G II" auf dem Markt bekannt und erhältlich. Diese Bedienfelder bestehen im wesentlichen aus einer vor den Kochzonen in die Herdblende oder neben den Kochzonen in den Bereich der Abstell- und Arbeitsplatte eines Herdes angeordneten, durchbrechungsfreien und undurchsichtig eingefärbten Isolierstoffplatte, unter der zum Beispiel kontaktlose Schalter (Berührungsschalter, wie beispielsweise Infrarot-Sensoren) und optoelektronische Anzeigeeinheiten in Form von punktförmigen Leuchtdioden oder von Siebensegment-Leuchtdioden angeordnet sind. Ein Bedienfeld dieser Art ist zum Beispiel in der DE 101 07 206 A1 der Anmelderin beschrieben.

Die herkömmlichen Bedienfelder der oben beschriebenen Art enthalten üblicher Weise nur eine Art eines Bedienelements(zum Beispiel ausschließlich Infrarot-Sensoren), um die Schaltung und die Auswerteschaltung des Bedienfeldes möglichst einfach zu halten. Es existiert jedoch der Wunsch, auch Bedienfelder mit verschiedenen Arten von Bedienelementen (zum Beispiel eine Kombination von Infrarot-Sensoren und kapazitiven Berührungsschaltern) herzustellen. Hierbei soll jedoch die Schaltung und die Auswerteschaltung des Bedienfeldes nicht unnötig kompliziert werden oder stark modifiziert werden müssen.

Der vorliegenden Erfindung liegt daher die Aufgabe zugrunde, ein Bedienfeld für elektronische Geräte bereitzustellen, das zwei Arten von Bedienelementen enthält, wobei die Bedienelemente der zweiten Art in das Bedienfeld ohne eine Modifizierung der Schaltung und der Auswerteschaltung des bestehenden Bedienfeldes mit den Bedienelementen der ersten Art integriert werden können.

Diese Aufgabe wird erfindungsgemäß durch ein Bedienfeld mit den Merkmalen des Anspruchs 1 gelöst. Bevorzugte Aus- bzw. Weiterbildungen des erfindungsgemäßen Bedienelements sind in den Unteransprüchen angegeben.

Das Bedienfeld für ein elektronisches Gerät, insbesondere ein elektronisches Haushaltsgerät wie beispielsweise ein Kochfeld, ein Gargerät, ein Mikrowellengerät oder dergleichen, enthält mehrere Bedienelemente zum Eingeben von Stellwerten in eine Steuerung des elektronischen Geräts und eine Anzeigeeinheit zum Anzeigen von eingegebenen Stellwerten und/oder anderen Informationen, wobei die mehreren Bedienelemente fortlaufend im Wechsel freigegeben werden. Die mehreren Bedienelemente enthalten wenigstens ein Bedienelement einer ersten Art und wenigstens ein Bedienelement einer zweiten Art, wobei das wenigstens eine Bedienelement der zweiten Art ein Berührungsschalter mit einem digitalen, z.B. (High/Low-)Ausgangssignal ist. Zur Integration des Bedienelements der zweiten Art in ein bestehendes Bedienfeld mit Bedienelementen der ersten Art ist zwischen die Steuerung und das Bedienelement der zweiten Art eine Transistorschaltung geschaltet ist, welche das Schaltverhalten des Bedienelements der zweiten Art an das Schaltverhalten des wenigstens einen Bedienelements der ersten Art adaptiert.

Das wenigstens eine Bedienelement der zweiten Art kann insbesondere ein kapazitiver Berührungsschalter sein.

Gemäß einem ersten Aspekt der Erfindung werden die Bedienelemente der zweiten Art in ein Bedienfeld integriert, bei dem die Bedienelemente der ersten Art analoge Ausgangssignale liefern und insbesondere Infrarot-Sensoren sind.

Gemäß einem zweiten Aspekt der Erfindung werden die Bedienelemente der zweiten Art in ein Bedienfeld integriert, bei dem die Anzeigeeinheit eine Mehrsegmentanzeige ist, deren Anzeigesegmente in einem fortlaufenden Wechsel freigegeben werden, wobei jedem Anzeigesegment der Mehrsegmentanzeige eines der mehreren Bedienelemente zugeordnet ist und das wenigstens eine Bedienelement der ersten Art ein Ein-/Aus-Schalter, vorzugsweise ein elektro-mechanischer Taster ist.

Weitere Einzelheiten, Merkmale und Vorteile ergeben sich aus der nachfolgenden Beschreibung verschiedener Ausführungsbeispiele eines erfindungsgemäßen Bedienfeldes. Es zeigen:
- Fig. 1: ein Blockschaltbild eines wesentlichen Teils einer Schaltung eines Bedienfeldes mit mehreren Bedienelementen gemäß einem ersten Ausführungsbeispiel der vorliegenden Erfindung;
- Fig. 2: ein Diagramm zur Erläuterung des Signal Verlaufs am Schaltungsausgang (A) von Fig. 1 für eines der Bedienelemente; und
- Fig. 3: ein Blockschaltbild eines wesentlichen Teils einer Schaltung eines Bedienfeldes mit mehreren Bedienelementen gemäß einem zweiten Ausführungsbeispiel der vorliegenden Erfindung.

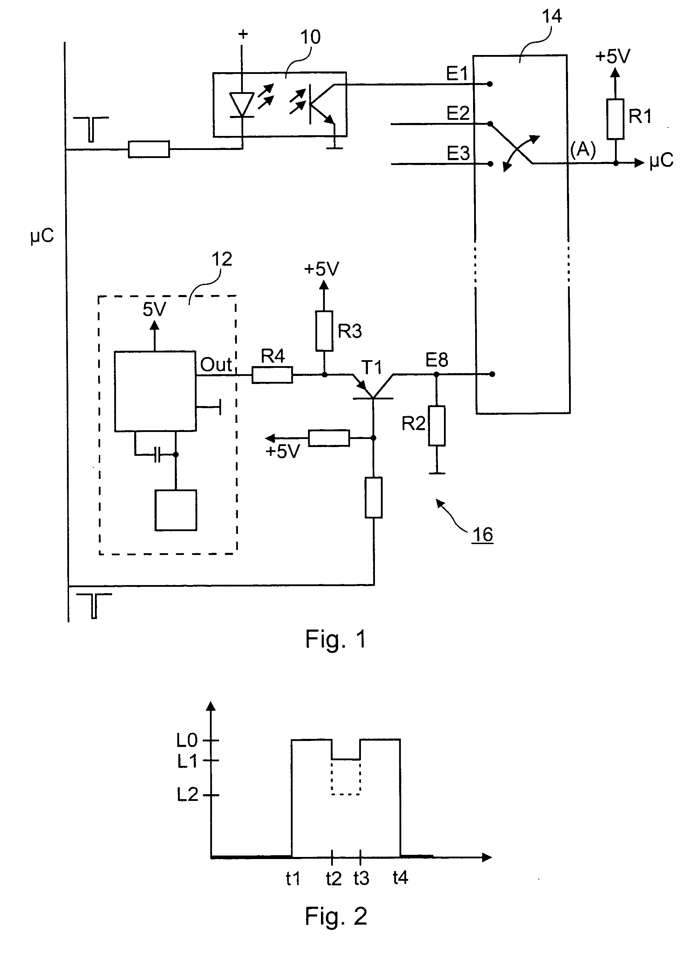

Anhand von Fig. 1 und 2 werden zunächst der Aufbau und die Funktionsweise eines ersten Ausführungsbeispiels eines erfindungsgemäßen Bedienfeldes beschrieben.

Das Bedienfeld umfasst insgesamt acht Bedienelemente, von denen in Fig. 1 der Einfachheit halber nur ein Infrarot-Sensor 10 als erstes Bedienelement der ersten Art und ein kapazitiver Berührungsschalter 12 als achtes Bedienelement der zweiten Art gezeigt sind. Die zweiten bis siebten Bedienelemente können jeweils als Bedienelement der ersten oder der zweiten Art ausgebildet sein. Üblicher Weise ist die Mehrzahl der Bedienelemente ein Bedienelement der ersten Art, da diese Bestandteil eines herkömmlichen Bedienfeldes sind, in welches wenigstens ein Bedienelement der zweiten Art integriert werden soll.

Während in diesem Ausführungsbeispiel als Bedienelement der zweiten Art 12 ein kapazitiver Berührungsschalter verwendet wird, sei an dieser Stelle ausdrücklich darauf hingewiesen, dass als Bedienelemente der zweiten Art grundsätzliche alle Arten von Bedienelementen eingesetzt werden können, die ein digitales, z.B. ein High/Low-Ausgangssignal erzeugen. Hierzu zählen neben den kapazitiven Berührungsschaltern auch Ein-/Aus-Schalter wie zum Beispiel mechanische Taster.

Da ferner der Aufbau und die Funktionsweise von Infrarot-Sensoren, kapazitiven Berührungsschaltern in Zusammenhang mit Bedienfeldern für elektronische Haushaltsgeräte dem Fachmann hinlänglich bekannt sind, wird im Rahmen dieser Beschreibung auf nähere Ausführungen hierzu verzichtet.

Ein Multiplexer 14 schaltet nacheinander, d.h. fortlaufend im Wechsel seinen Ausgang (A), der mit einer Steuerung (µC) des Bedienfeldes verbunden ist, an die acht Eingänge E1 bis E8, an welche die acht Bedienelemente der ersten bzw. der zweiten Art 10, 12 angeschlossen sind. Während der Ausgang des Infrarot-Sensors 10 direkt mit dem Eingang E1 des Multiplexers 14 verbunden ist, ist zwischen den Ausgang des kapazitiven Berührungsschalters 12 und den Eingang E8 eine Transistorschaltung 16 geschaltet. Diese Transistorschaltung 16 soll das Schaltverhalten des kapazitiven Berührungsschalters 12 an das Schaltverhalten eines Infrarot-Sensors 10 adaptieren, wie weiter unten näher erläutert, sodass außer dem Zwischenschalten der Transistorschaltung 16 zur Integration des kapazitiven Berührungsschalters keine weiteren Änderungen oder Modifikationen an Hard- und Softwarekomponenten eines bestehenden herkömmlichen Bedienfeldes vorgenommen werden müssen.

Anhand des schematischen Diagramms von Fig. 2 wird nun zunächst der Signalverlauf am Ausgang (A) des Multiplexers 14 beschrieben, wenn der Ausgang (A) mit einem Eingang (E) verbunden ist, an dem ein Infrarot-Sensor 10 angeschlossen ist.

Zum Zeitpunkt t₁ wird der Ausgang (A) des Multiplexers 14 zum Beispiel mit dem Eingang E1 verbunden und damit der an E1 angeschlossene Infrarot-Sensor 10 freigegeben. Die Sendediode des Infrarotsensors 10 wird erst zum Zeitpunkt t₂ später als t₁ durch ein entsprechendes Signal von der Steuerung (µC) eingeschaltet, sodass für die Zeitdauer τ₁₂ zwischen t₁ und t₂ zunächst ein Dunkelpegel bzw. ein von Fremdlicht erzeugter Pegel L0 erzeugt wird. Mit dem Einschalten der Sendediode des Infrarot-Sensors 10 zum Zeitpunkt t₂ ergibt sich ein Reflexionspegel L1 < L0, wenn der Infrarot-Sensor 10 nicht betätigt wird, und ein Betätigungspegel L2 < L1, wenn der Infrarot-Sensor 10 betätigt, d.h. mit einem Finger berührt wird. Es handelt sich hier also um ein analoges Ausgangssignal. Zum Zeitpunkt t₃ nach t₂ wird die Sendediode des Infrarot-Sensors 10 wieder ausgeschaltet, sodass für die Zeitdauer τ₃₄ zwischen dem Zeitpunkt t₃ und dem späteren Zeitpunkt t₄, wenn der Multiplexer 14 von Eingang E1 zum nächsten Eingang E2 wechselt, wieder der Pegel L0 am Ausgang (A) erzeugt wird. Die Differenz zwischen den Pegeln L1 und L2 wird zur Auswertung in der Steuerung herangezogen.

Es werden nun der Aufbau und die Funktionsweise der Transistorschaltung 16 wieder unter Bezugnahme auf Fig. 1 näher erläutert.

Der Ausgang des kapazitiven Berührungsschalters 12 (zum Beispiel ein QT320) ist über einen pnp-Transistor T1 mit dem Eingang E8 des Multiplexers 14 verbunden. Die Basis des Transistors T1 ist mit der Steuerung (µC) verbunden, sodass der Transistor T1 analog zum Einschalten der Sendediode des Inrarot-Sensors 10 durch ein entsprechendes Signal von der Steuerung leitend gemacht werden kann. Der Emitter des Transistors T1 ist über einen Widerstand R4 mit dem Ausgang des kapazitiven Berührungsschalters 12 und über einen Widerstand R3 mit einer Spannungsquelle (z.B. + 5V) verbunden. Der Eingang E8 des Multiplexers 14 ist sowohl mit dem Kollektor des Transistors T1 als auch über einen Widerstand R2 mit Masse verbunden. Schließlich ist der Ausgang (A) des Multiplexers 14 sowohl mit der Steuerung (µC) als auch über einen Widerstand R1 mit einer Spannungsquelle (z.B. + 5V) verbunden.

Gibt nun der Multiplexer 14 den kapazitiven Berührungsschalter 12 frei, d.h. verbindet er zum Zeitpunkt t₁ seinen Ausgang (A) mit seinem Eingang E8, so ergibt sich, da der Transistor T1 zu diesem Zeitpunkt nicht leitend ist, aufgrund der Spannungsteilung zwischen dem Widerstand R1 am Ausgang (A) und dem Widerstand R2 am Eingang E8 am Ausgang (A) des Multiplexers 14 ein Pegel L0, der dem Fremdlichtpegel L0 des Infrarot-Sensors 10 entspricht. Im Zeitraum τ₂₃ zwischen einem Zeitpunkt t₂ nach t₁ und einem Zeitpunkt t₃ nach t₂ schaltet die Steuerung (µC) durch das oben erwähnte Signal den Transistor T1 leitend. Bei nicht betätigtem Berührungsschalter 12 (digitaler Ausgangspegel "High") entsteht in diesem Zeitraum τ₂₃ über die Spannungsteilungen zwischen R1, R2, R3 und R4 am Ausgang (A) des Multiplexers 14 ein Signal mit einem Pegel L1, der dem Reflexionspegel L1 des Infrarot-Sensors 10 entspricht. Bei betätigtem kapazitivem Berührungsschalter 12 (digitaler Ausgangspegel "Low") dagegen entsteht in diesem Zeitraum τ₂₃ über die Spannungsteilungen zwischen R1, R2, R3 und R4 am Ausgang (A) des Multiplexers 14 ein Signal mit einem Pegel L2, der dem Betätigungspegel L2 des Infrarot-Sensors 10 entspricht. Nach dem "Ausschalten" des Transistors T1 zum Zeitpunkt t₃ wird am Ausgang (A) des Multiplexers 14 bis zum Wechsel von Eingang E8 zu Eingang E1 zum Zeitpunkt t₄ ein Signalpegel L0 erzeugt.

Auf diese Weise ist am Ausgang (A) des Multiplexers 14 das Schaltverhalten eines Infrarot-Sensors 10 nachgebildet, selbst wenn der Ausgang (A) mit dem Eingang E8 verbunden ist, an welchem der kapazitive Berührungsschalter 12 angeschlossen ist. Die Steuerung (µC) kann daher den üblichen Auswertungsalgorithmus eines herkömmlichen Bedienfeldes, welches ausschließlich Infrarot-Sensoren 10 enthält, verwenden.

Von der Anmelderin erprobte Werte für die Widerstände R1, R2, R3 und R4 zur Erzielung der gewünschten Spannungsteilungen in den Zeiträumen τ₁₂, τ₂₃ und τ₃₄ sind zum Beispiel R1 = 33 kΩ, R2 = 680 kΩ, R3 = 10 kΩ und R4 = 20 kΩ, bei einer Spannungsversorgung von + 5 V, einem kapazitiven Berührungsschalter, umfassend den IC-Baustein QT320 der Quantum Research Corp. Hamble, Southampton, UK, mit daran angeschlossenem kapazitivem Sensorelement, und einem Multiplexer MUX4051.

Es sei an dieser Stelle erwähnt, dass es für die Funktionsfähigkeit der Erfindung nicht unbedingt notwendig wäre, beide Pegel L0 und L1 des Infrarot-Sensors 10 durch die Transistorschaltung 16 nachzubilden.

Wie oben erläutert, ist es mittels der Transistorschaltung 16 möglich, Bedienelemente 12 mit einem digitalen (z.B. High/Low-)Ausgangssignal ohne weitere Anpassungen oder Modifikationen der bestehenden Hardware und Software in ein Bedienfeld zu integrieren, welches ausschließlich Infrarot-Sensoren mit analogem Ausgangssignal enthält. Es können somit problemlos Bedienfelder mit gemischten Bedienelement-Bestückungen hergestellt werden.

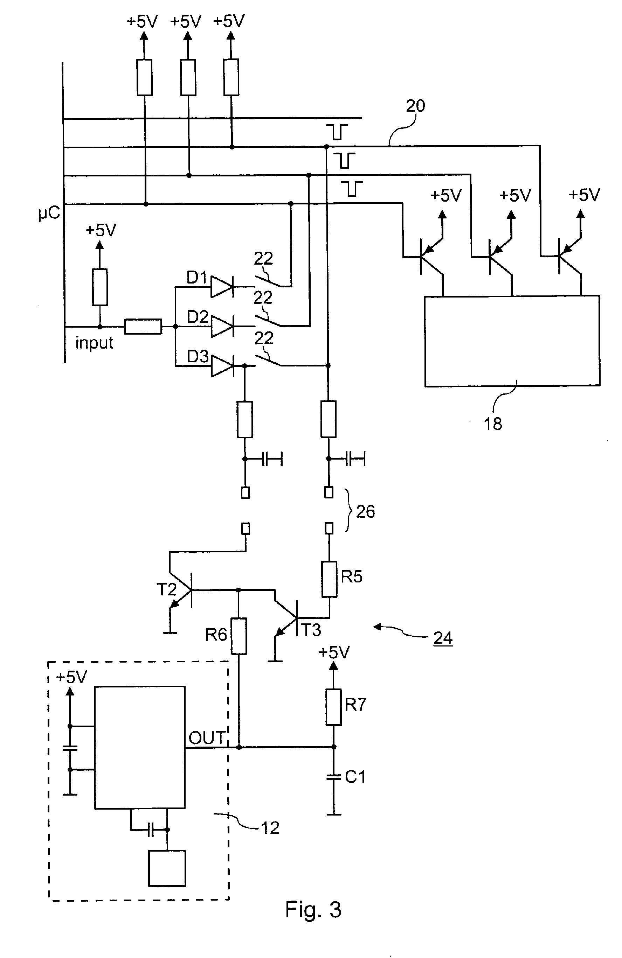

Bezug nehmend auf Fig. 3 wird nachfolgend ein zweites Ausführungsbeispiel eines erfindungsgemäßen Bedienfeldes beschrieben.

Das Bedienfeld umfasst insgesamt drei elektro-mechanische Taster 22 als Bedienelemente der ersten Art, wobei der dritte Taster 22 deaktiviert und durch einen kapazitiven Berührungsschalter 12 als Bedienelement der zweiten Art ersetzt ist. Während als Bedienelement der zweiten Art 12 ein kapazitiver Berührungsschalter verwendet wird, sei an dieser Stelle ausdrücklich darauf hingewiesen, dass als Bedienelemente der zweiten Art auch bei diesem Ausführungsbeispiel grundsätzliche alle Arten von Bedienelementen eingesetzt werden können, die ein digitales Ausgangssignal erzeugen.

Das Bedienfeld umfasst ferner eine Anzeigeeinheit 18 in Form einer Mehrsegmentanzeige, wobei jedem Anzeigesegment dieser Mehrsegmentanzeige eines der mehreren Bedienelemente 22 zugeordnet ist. Die einzelnen Anzeigesegmente werden durch die Steuerung (µC) über Verbindungsleitungen 20 fortlaufend im Wechsel angesteuert bzw. freigegeben, wie in Fig. 3 durch die versetzten Signale auf den Verbindungsleitungen 20 angedeutet. Über einen speziellen Eingang (Input) der Steuerung (µC) wird dann fortlaufend im Wechsel der Signalpegel des dem zu diesem Zeitpunkt freigegebenen Anzeigesegment zugeordneten Bedienelements 22 abgefragt. Mit anderen Worten liegen die elektro-mechanischen Tasten 10 in einem Display Scan und werden über einen gemeinsamen Eingang (Input) der Steuerung (µC) eingelesen. Wird zum Beispiel der erste Taster 22 während des Scans des ihm zugeordneten Anzeigesegments betätigt, so empfängt die Steuerung (µC) am Eingang (Input) über die Diode D1 den "Low"-Pegel der Verbindungsleitung, was als Betätigung des Tasters 22 ausgewertet wird.

Soll nun in dieses Bedienfeld ein kapazitiver Berührungsschalter 12 integriert werden, so darf die Betätigung dieses Berührungsschalters 12 nur während der Freigabe des ihm zugeordneten Anzeigesegments der Anzeigeeinheit 18 an die Steuerung (µC) weitergemeldet werden. Da der kapazitive Berührungsschalter 12 aber während seiner Betätigung hier konstant einen digitalen Signalpegel "High" an seinem Ausgang liefert (der IC-Baustein QT320 ist programmierbar, ob er bei einer Betätigung einen "High"- oder einen "Low-"Pegel liefern soll), muss zwischen den kapazitiven Berührungsschalter 12 und das herkömmliche Bedienfeld bzw. dessen Steuerung eine geeignete Transistorschaltung 24 zum Beispiel über eine Steckverbindung 26 geschaltet werden.

Es werden nun der Aufbau und die Funktionsweise der Transistorschaltung 24 unter Bezugnahme auf Fig. 3 näher erläutert.

Die beiden Anschlüsse des deaktivierten dritten Tasters 22 sind zu der Steckverbindung 26 heraus geführt. Die Transistorschaltung 24 enthält insbesondere einen ersten npn-Transistor T2, dessen Kollektor mit dem mit dem Eingang (Input) der Steuerung (µC) verbundenen Anschluss des Tasters 22 und dessen Emitter mit Masse verbunden ist, sowie einen zweiten npn-Transistor T3, dessen Basis über einen Widerstand R5 mit dem mit der Verbindungsleitung 20 zu der Anzeigeeinheit 18 verbundenen Anschluss des Tasters 22 und dessen Emitter ebenfalls mit Masse verbunden ist. Die Basis des ersten Transistors T2 ist mit dem Kollektor des zweiten Transistors T3 verbunden. Ferner ist die Verbindung zwischen der Basis des ersten Transistors T2 und dem Kollektor des zweiten Transistors T3 über einen weiteren Widerstand R6 mit dem Ausgang (OUT) des kapazitiven Berührungsschalters 12 verbunden.

Der mit der Basis des zweiten Transistors T3 verbundene Widerstand R5 ist so zu wählen, dass zum einen der Scan-Vorgang der Anzeigeeinheit 18 nicht belastet wird und zum anderen der zweite Transistor T3 mit steilen Ausgangsflanken schalten kann. Letzteres ist notwendig, um Verzögerungen zwischen dem Einschalten des Scans, d.h. der Zuordnung des entsprechenden Anzeigesegments und der beginnenden Auswertung in der Steuerung (µC) zu vermeiden.

Solange der Scan im "High"-Zustand ist, d.h. das dritte Anzeigesegment der Anzeigeeinheit 18 nicht freigegeben ist, ist der zweite Transistor T3 leitend und verhindert dadurch, dass das Ausgangssignal des kapazitiven Berührungsschalters 12 weitergeleitet wird. Ist jedoch das dritte Anzeigesegment der Anzeigeeinheit 18 freigegeben ("Low"-Zustand), sperrt der zweite Transistor T3 und gibt damit das Ausgangssignal des kapazitiven Berührungsschalters 12 frei.

Bei gesperrtem Transistor T3 wird also das Ausgangssignal des kapazitiven Berührungsschalters 12 freigegeben und an die Basis des ersten Transistors T2 gelegt. Wird der kapazitive Berührungsschalter 12 in diesem Moment betätigt, d.h. erzeugt er ein digitales Ausgangssignal des "High"-Pegels, so wird der erste Transistor T2 leitend und die Kathode der Diode D3 wird über den ersten Transistor T2 auf Masse gezogen, was einer Betätigung des Tasters 22 entspricht. Wird dagegen der kapazitive Berührungsschalter 12 in diesem Moment nicht betätigt, so sperrt auch der erste Transistor T2 und der Steuerung (µC) wird kein Tastenbetätigungssignal, sondern der "High"-Pegel der am Eingang (Input) angeschlossenen Spannungsquelle zugeführt.

Auf diese Weise wird am Eingang (Input) der Steuerung das Schaltverhalten eines elektro-mechanischen Tasters 22 im Digit-Scan nachgebildet, selbst wenn statt des elektro-mechanischen Tasters 22 ein angeschlossener kapazitiver Berührungsschalter 12 betätigt wird. Es ist daher mittels der Transistorschaltung 24 möglich, Bedienelemente 12 mit einem digitalen (z.B. High/Low-) Ausgangssignal ohne weitere Anpassungen oder Modifikationen der bestehenden Hardware und Software in ein Bedienfeld zu integrieren, welches ausschließlich Ein-/Aus-Schalter sowie elektromechanische Taster 22 enthält, die im Digit-Scan abgefragt werden. Es können somit problemlos Bedienfelder mit gemischten Bedienelement-Bestückungen hergestellt werden.

Der mit der Verbindung zwischen der Basis des ersten Transistors T2 und dem Kollektor des zweiten Transistors T3 verbundene Widerstand R6 hat noch eine weitere Aufgabe. Wie in Fig. 3 dargestellt, ist in der Transistorschaltung 24 eine Reihenschaltung eines weiteren Widerstandes R7 und einer Kapazität C1 vorgesehen, deren Mittelabgriff ebenfalls mit dem Ausgang (OUT) des kapazitiven Berührungsschalters 12 verbunden ist. Der kapazitive Berührungsschalter 12 generiert möglicher Weise unerwünschte Impulse, welche mit dem Widerstand R7 und der Kapazität C1 wegintegriert werden können. Der Widerstand R6 entkoppelt dabei den ersten Transistor T2 von der aus R7×C1 gebildeten Zeitkonstante, die zu einer verschliffenen Flanke am Kollektor des ersten Transistors T2 führen und damit die Auswertung des kapazitiven Berührungsschalters 12 in der Steuerung (µC) verhindern würde.

### Bezugsziffernliste

- 10: Bedienelement der ersten Art (Infrarot-Sensoren)
- 12: Bedienelement der zweiten Art
- 14: Multiplexer
- 16: Transistorschaltung
- 18: Anzeigeeinheit
- 20: Verbindungsleitungen
- 22: Bedienelement der ersten Art (elektro-mechanische Taster)
- 24: Transistorschaltung
- 26: Steckverbindung

## Patentansprüche

1. Bedienfeld für ein elektronisches Gerät, mit mindestens einem Bedienelement (10, 12; 22) zum Eingeben von Stellwerten in eine Steuerung des elektronischen Geräts und einer Anzeigeeinheit (18) zum Anzeigen von eingegebenen Stellwerten und/oder anderen Informationen, wobei die Steuerung zum Anschluss mindestens eines Bedienelements einer ersten Art (10;22) ausgelegt ist,
**dadurch gekennzeichnet,**
**dass** zusätzlich zum oder anstelle des Bedienelements der ersten Art (10;22) auch wenigstens ein Bedienelement einer zweiten Art (12) an die Steuerung anschließbar ist;
wobei das wenigstens eine Bedienelement der zweiten Art (12) ein Berührungsschalter mit einem digitalen Ausgangssignal ist und
wobei zwischen die Steuerung und das Bedienelement der zweiten Art (12) eine Transistorschaltung (16; 24) geschaltet ist, welche das Schaltverhalten des Bedienelements der zweiten Art (12) an das Schaltverhalten des Bedienelements der ersten Art (10; 22) adaptiert.

2. Bedienfeld nach Anspruch 1,
**dadurch gekennzeichnet,**
**dass** das wenigstens eine Bedienelement der zweiten Art (12) ein kapazitiver Berührungsschalter ist.

3. Bedienfeld nach Anspruch 1 oder 2,
**dadurch gekennzeichnet,**
**dass** das wenigstens eine Bedienelement der ersten Art (10) ein analoges Ausgangssignal liefert und vorzugsweise ein Infrarot-Sensor ist.

4. Bedienfeld nach Anspruch 3,
**dadurch gekennzeichnet,**
**dass** die Transistorschaltung (16) einen Transistor (T1) und mehrere Widerstände (R2, R3, R4) enthält, die je nach Schaltungszustand des Transistors (T1) aufgrund entsprechender Spannungsteilungen Signale mit verschiedenen Ausgangspegeln (L0, L1, L2) an die Steuerung ausgeben.

5. Bedienfeld nach Anspruch 3 oder 4,
**dadurch gekennzeichnet,**
**dass** die mehreren Bedienelemente (10, 12; 22) fortlaufend im Wechsel freigegeben werden und die Ausgangssignale der mehreren Bedienelemente (10, 12, 22) über einen Multiplexer (14) fortlaufend im Wechsel an die Steuerung ausgegeben werden.

6. Bedienfeld nach Anspruch 1 oder 2,
**dadurch gekennzeichnet,**
**dass** die Anzeigeeinheit (18) eine Mehrsegmentanzeige ist, deren Anzeigesegmente in einem fortlaufenden Wechsel freigegeben werden, wobei jedem Anzeigesegment der Mehrsegmentanzeige eines der mehreren Bedienelemente (22, 12) zugeordnet ist; und
**dass** das wenigstens eine Bedienelement der ersten Art (22) ein Ein-/Aus-Schalter, vorzugsweise ein elektro-mechanischer Taster ist.

7. Bedienfeld nach Anspruch 6,
**dadurch gekennzeichnet,**
**dass** die Transistorschaltung (24) zwei Transistoren (T2, T3) enthält, die so geschaltet sind, dass der erste Transistor (T2) durch das Ausgangssignal des Bedienelements der zweiten Art (12) nur bei Freigabe des zugeordneten Anzeigesegments geschaltet wird.
